Europäisches Patentamt

European Patent Office

Office européen des brevets

(11) Veröffentlichungsnummer: **0 259 394 B1**

# (12) EUROPÄISCHE PATENTSCHRIFT

(45) Veröffentlichungstag der Patentschrift:
21.08.91 Patentblatt 91/34

(21) Anmeldenummer: 87901365.4

(22) Anmeldetag: 28.02.87

(86) Internationale Anmeldenummer:
PCT/DE87/00080

(87) Internationale Veröffentlichungsnummer:
WO 87/05450 11.09.87 Gazette 87/20

(51) Int. Cl.⁵: $H01R\ 43/052$, $H01B\ 13/00$,
$H05K\ 13/06$

## (54) WERKZEUG ZUM VERLEGEN VON KABELN.

(30) Priorität: 04.03.86 DE 3607069

(43) Veröffentlichungstag der Anmeldung:
16.03.88 Patentblatt 88/11

(45) Bekanntmachung des Hinweises auf die
Patenterteilung:
21.08.91 Patentblatt 91/34

(84) Benannte Vertragsstaaten:
CH DE FR GB IT LI SE

(56) Entgegenhaltungen:
EP-A- 0 116 475
DE-B- 1 290 210
DE-B- 1 290 215
GB-A- 2 059 302

(73) Patentinhaber: KOMAX AG
Industriestrasse
CH-6036 Dierikon-Luzern (CH)

(72) Erfinder: SCHLAICH, Gerd
Schellingstrasse 12
W-7255 Rutesheim (DE)
Erfinder: REICHEL, Jürgen
Schwalbenweg 3
W-7319 Dettingen-Teck (DE)

(74) Vertreter: Münich, Wilhelm, Dr. et al
Kanzlei Münich, Steinmann, Schiller
Willibaldstrasse 36/38
W-8000 München 21 (DE)

EP 0 259 394 B1

Anmerkung: Innerhalb von neun Monaten nach der Bekanntmachung des Hinweises auf die Erteilung
des europäischen Patents kann jedermann beim Europäischen Patentamt gegen das erteilte europäische Patent Einspruch einlegen. Der Einspruch ist schriftlich einzureichen und zu begründen. Er gilt
erst als eingelegt, wenn die Einspruchsgebühr entrichtet worden ist (Art. 99(1) Europäisches Patentübereinkommen).

## Beschreibung

<u>Technisches Gebiet</u>

Die Erfindung bezieht sich auf ein Werkzeug zum Verlegen von Kabeln gemäß dem Oberbegriff des Patentanspruchs 1, wie es beispielsweise aus der DE-B-1290210 bekannt ist.

<u>Stand der Technik</u>

Gegenwärtig werden elektrische Kabel überwiegend manuell verlegt. Ferner ist es bekannt, in starr automatisierten Anschlagmaschinen eine oder mehrere Einzelleitungen von zwangsgeführten Greifern gebildete Führerelemente parallel zu verlegen und nach dem Verlegen abzulängen.

Werkzeuge zum Verlegen von Kabeln, die sich zur Verwendung in Verbindung mit Handhabungsgeräten, beispielsweise Industrierobotern eignen, haben sich bislang nicht durchgesetzt, da sie entweder zu kompliziert oder zu störanfällig sind.

<u>Darstellung der Erfindung</u>

Der Erfindung liegt die Aufgabe zugrunde, ein Werkzeug zum Verlegen von Kabeln anzugeben, das sich unter anderem zur Verwendung mit Handhabungsgeräten, wie Industrierobotern etc. eignet.

<u>Wege zur Ausführung der Erfindung</u>

Eine erfindungsgemäße Lösung dieser Aufgabe ist in den Patentansprüchen gekennzeichnet.

Das erfindungsgemäße Werkzeug ist so ausgebildet, daß es an einem Handhabungsgerät, beispielsweise einem Industrieroboter anbringbar ist. Dieses Anbringen kann beispielsweise durch direktes Anflanschen oder gemäß Anspruch 3 dadurch erfolgen, daß das Werkzeug eine Werkzeugwechselvorrichtung aufweist, mit der das Werkzeug bei Bedarf vom Industrieroboter gegriffen und wieder abgelegt werden kann.

In dem Werkzeug wird das Kabel in einem Führungsrohr und einem Verlegerohr geführt, aus dem das Kabel austritt. Besonders vorteilhaft ist es dabei, wenn das Führungsrohr und das Verlegerohr aus einem Material bestehen, auf dem das Mantelmaterial des zu verlegenden Kabels besonders gleitet.

Die eigentliche Verlegebewegung erfolgt durch Verfahren des Industrieroboters, so daß auf die Durchführung der Verlegebewegung nicht näher eingegangen werden muß.

In dem Führungsrohr befinden sich zwei Transporträder, die ein Motor antreibt, und die das Kabel durch das Führungsrohr und das Verlegerohr transportieren. Der Motor kann natürlich beispielsweise ein pneumatisch betätigter Motor sein. Besonders vorteilhaft ist es jedoch, gemäß Anspruch 2 als Motor einen Elektromotor zu verwenden, der beispielsweise über ein Getriebe die beiden links und rechts vom Kabel angebrachten Antriebsräder antreibt. Die Steuerung des Industrieroboters kann dabei die Umdrehungszahl des Elektromotors und damit den Vorschubweg des Kabels steuern, so daß in einfacher Weise in das erfindungsgemäße Werkzeug eine programmierbare Kabellängen-Meßeinrichtung integrierbar ist.

Das Werkzeug weist ferner eine Ablängeinrichtung auf, die erfindungsgemäß aus einer Schneide und einer Gegenschneide bestehen, die so gestaltet sind, daß ein Umbiegen des abgelenkten Kabels verhindert wird. Gleichzeitig bilden die Schneide und die Gegenschneide einen Einführkegel bzw. einen Einführtrichter für die nachfolgende Vorschubbewegung.

Gemäß Anspruch 5 kann die Schneide pneumatisch senkrecht zur Kabelachse verschoben werden. Die Rückstellbewegung erfolgt dabei über federn. Dabei ist es möglich, die Schnittkraft extern beispielsweise vom Industrieroboter einzuleiten.

In jedem falle ist es jedoch vorteilhaft, wenn die Stellung der Schneide mittels eines Näherungsschalters ermittelt wird.

Darüber hinaus ist es vorteilhaft, wenn sowohl im Anschluß an die Ablängeinrichtung als auch im Verlegerohr Lichtschranken vorgesehen sind, mit denen überprüft wird, ob ein Kabel vorhanden ist.

Bei einer weiteren — im Anspruch 4 folgende gekennzeichneten — vorteilhaften Weiterbildung ist ein zusätzlicher Klemmhebel vorgesehen, der gegebenenfalls pneumatisch betätigbar ist. Dieser Klemmhebel legt bei Nichtbetätigung das Kabel im Führungsrohr fest, so daß beim Weglegen des Werkzeuges durch den Industrieroboter das Kabel nicht aus dem führungsrohr gezogen werden kann. Die Stellung des Klemmhebels wird gemäß Anspruch 6 vorteilhafterweise mittels eines Näherungsschalters überwacht und an die Steuereinheit des Industrieroboters weitergegeben.

Weiterhin ist es vorteilhaft, mindestens eines der Transporträder wegschwenkbar zu gestalten, so daß bei geöffnetem Klemmhebel und weggeschwenktem Transportrad das Kabel frei durch das führungs-und das Verlegerohr gezogen werden kann. Im Hinblick auf die Integration des erfindungsgemäßen Werkzeugs in einem Industrieroboter ist es selbstverständlich vorteilhaft, auch die Bewegung des Transportrades mittels eines Näherungsschalters zu überwachen.

Die Erfindung wird nachstehend anhand eines Ausführungsbeispieles unter Bezugnahme auf die Zeichnung näher beschrieben, in der zeigen :

Kurze Beschreibung der Zeichnungen

Figur 1    einen ersten Längsschnitt durch dieses Ausführungsbeispiel, und

Figur 2    einen zweiten um 90 Grad gegenüber Figur 1 gedrehten Längsschnitt.

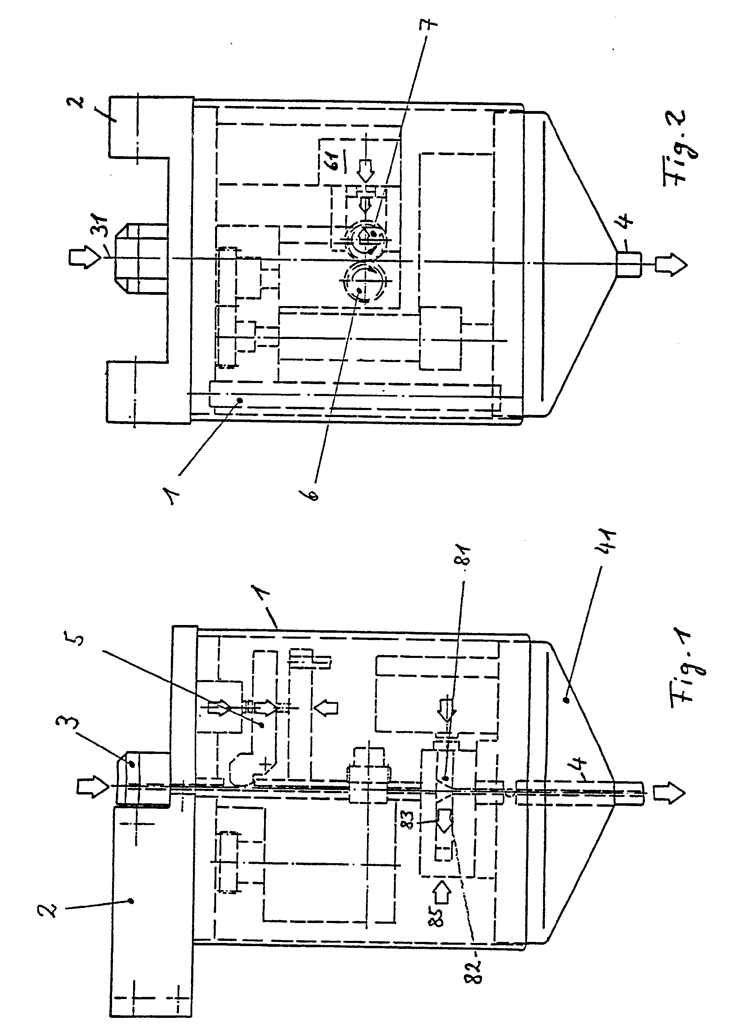

Das in den Figuren 1 und 2 dargestellte Ausführungsbeispiel eines erfindungsgemäßen Werkzeuges zum Verlegen von Kabeln weist ein Gehäuse 1 auf, in dem sämtliche funktionselemente untergebracht sind, und an dem eine Werkzeugwechselvorrichtung 2 angebracht ist, mit der ein Industrieroboter das Werkzeug bei Bedarf greifen und wieder ablegen kann.

In dem Gehäuse 1 befindet sich ein Führungsrohr 3 für das zu verlegende Kabel mit einer Eintrittsöffnung 31 für das Kabel sowie ein Verlegerohr 4, aus dem das zu verlegende Kabel austritt.

In dem Gehäuse 1 ist ein (beispielsweise) pneumatisch betätigter Hebel 5 vorgesehen, der zum festklemmen des Kabels im Werkzeug dient. Hierdurch wird verhindert, daß beim Ablegen des Verlegewerkzeuges im Werkzeugmagazin das Kabel aus dem Werkzeug gezogen werden kann. Die Verriegelung des Kabels erfolgt damit energieunabhängig, wobei es möglich ist, über einen nicht im einzelnen dargestellten Näherungsschalter die Schaltstellung des Hebels zu überwachen.

Ferner ist ein Elektromotor 61 vorgesehen, der über ein nicht im einzelnen dargestelltes Getriebe zwei links und rechts vom Kabel angebrachte Antriebsräder 6 und 7 antreibt, die das Kabel durch das führungsrohr 3 und das Verlegerohr 4 vorschieben. Die Umdrehungszahl des Elektromotors kann von der Steuereinheit des nichtdargestellten Industrieroboters gesteuert werden, so daß das Kabel bei jedem vom Industrieroboter durchgeführten Verlegevorgang um einen bestimmten Vorschub vorgeschoben werden kann. Damit ergibt sich gleichzeitig —wenn der Schlupf vernachlässigt werden kann — eine programmierbare KabellängenMeßeinrichtung.

Das Antriebsrad 7 kann mit Hilfe eines nicht näher dargestellten Pneumatikzylinders vom Kabel weggeschwenkt werden, so daß das Kabel bei geöffnetem Klemmhebel 5 frei durch das Werkzeug gezogen werden kann.

Vorteilhaft ist es, wenn bei der Schwenkbewegung des Antriebsrades 7 die Zahnräder des Antriebs soweit im Eingriff bleiben, daß beim Einschwenken des Antriebsrades 7 in die Stellung, in der es das Kabel berührt, kein Verbaken der Zahnradpaarung möglich ist. Dabei ist es wiederum möglich, die Stellung des Antriebsrades 7 über einen nicht näher dargestellten integrierten Näherungsschalter zu erfassen.

Ferner weist das Werkzeug eine aus einer Schneide 81 und einer Gegenschneide 82 bestehenden Ablängeinrichtung 8 auf. Die Schneide 81 kann beispielsweise von einem Pneumatikzylinder in Richtung eines Pfeils 83, d.h. senkrecht zur Kabelachse bewegt werden.

Durch die in den Figuren dargestellte Gestaltung der Schneidenanordnung wird ein Umbiegen des abgelängten Kabels verhindert. Gleichzeitig bilden die Schneiden 81 und 82 für das aus dem führungsrohr 3 vorgeschobene andere Kabelende einen Einführkegel bei weiteren Vorschubbewegung.

Die Rückstellung der Schneide in Richtung des Pfeils 85 erfolgt über Federn. Dabei ist es möglich, die Stellung der Schneide über einen ebenfalls nicht dargestellten Näherungsschalter abzufragen und mittels einer nachgeschalteten Lichtschranke den Ablängvorgang abzufragen.

Der Befehl zum Ablängen des Kabels kann wiederum von der Steuereinheit des Industrieroboters gegeben werden.

Eine weitere Lichtschranke kann im Verlegerohr 4 angeordnet sein, mit der der Verlegevorgang kontrolliert werden kann.

Bei dem dargestellten Ausführungsbeispiel ist das Verlegerohr 4 in einem Deckel 41 gehalten. Dies erlaubt es, das Verlegerohr schnell auszuwechseln, so daß verschiedene Kabeldurchmesser ohne Umrüstaufwand verlegt werden können. Besonders vorteilhaft ist es jedoch in jedem falle, wenn das Verlegerohr aus einem Material besteht, auf dem das Ummantelungsmaterial des Kabels gut gleitet.

Vorstehend ist die Erfindung anhand eines Ausführungsbeispiels beschrieben worden. Innerhalb des Erfindungsgedankens, wie er in den Ansprüchen niedergelegt ist, sind natürlich Modifikationen möglich.

3

## Gewerbliche Verwertbarkeit

Das erfindungsgemäße Werkzeug wird zum Verlegen von Kabeln verwendet und besitzt eine Ablängeeinrichtung. Das Werkzeug ist an einem Handhabungsgerät, beispielsweise einem Industrieroboter anbringbar und durch dieses steuerbar.

## Patentansprüche

1. Werkzeug zum Verlegen von Kabeln mit einem Führungselement für die Kabel und einer, eine Schneide (81) auf weisende Ablängeinrichtung, wobei
   (a) das Werkzeug an einem Handhabungsgerät anbringbar und durch dieses steuerbar ist,
   (b) das Kabel im Werkzeug in einem Führungsrohr (3) und einem Verlegerohr (4) geführt ist und
   (c) zwei an dem Führungsrohr (3) angeordnete Transporträder (6, 7), die ein Motor (61) antreibt, das Kabel durch das Führungsrohr (3) und das Verlegerohr (4), transportien dadurch gekennzeichnet, daß,
   (d) die Ablängeinrichtung (8) eine gegenschneide (82) aufweist, und die Schneide (81) und die Gegenschneide (82) einen Trichter zum Einführen des Kabels in das Verlegerohr (4) bilden.

2. Werkzeug nach Anspruch 1, dadurch **gekennzeichnet**, daß der Motor ein Elektromotor ist, dessen Drehzahl und/oder Umdrehungszahl etc. das Handhabungsgerät steuert.

3. Werkzeug nach Anspruch 1 oder 2, dadurch **gekennzeichnet**, daß an dem Werkzeug eine Werkzeugwechselvorrichtung (2) angebracht ist.

4. Werkzeug nach einem der Ansprüche 1 bis 3, dadurch **gekennzeichnet**, daß ein Klemmhebel (5) vorgesehen ist, der im Ruhezustand das Kabel festklemmt.

5. Werkzeug nach Anspruch 4, dadurch **gekennzeichnet**, daß der Klemmhebel pneumatisch betätigt ist.

6. Werkzeug nach Anspruch 4 oder 5, dadurch **gekennzeichnet**, daß ein Näherungsschalter die Schaltstellung des Klemmhebels überwacht.

## Claims

1. Tool for laying cables, comprising a cable-guiding element and a length-cutting means including a blade (81), wherein
   (a) said tool is adapted to be attached to and controlled by a handling device,
   (b) said cable is guided inside the tube within a guide tube (3) and a laying tube (4), and wherein
   (c) two drive wheels (6, 7) disposed at said guide tube (3) and driven by a motor (61) are provided to advance said cable through said guide tube (3) and said laying tube (4),
   **characterized in** that
   (d) said length-cutting means (8) comprises a counter blade (82), and that said blade (81) and said counter blade (82) cooperate to form a funnel-shaped opening for feeding said cable into said laying tube (4).

2. Tool according to Claim 1,
**characterized in** that said motor is an electric motor whose speed and/or number of revolutions etc. serve to control said handling device.

3. Tool according to Claim 1 or 2,
**characterized in** that a tool change system (2) is provided at said tool.

4. Tool according to any of Claims 1 to 3,
**characterized in** that a clamping lever (5) is provided which in its inoperative position serves to clamp said cable.

5. Tool according to Claim 4,
**characterized in** that said clamping lever is adapted to be operated pneumatically.

6. Tool according to Claim 4 or 5,
**characterized in** that a proximity switch is provided for monitoring the switching position of said clamping lever.

## Revendications

1. Outil de pose de câbles avec un élément de guidage pour les câbles et un dispositif de tronçonnage présentant une lame (81), à ce sujet
   (a) l'outil est montable à un manipulateur et guidable au moyen de celui-ci,

(b) le câble dans l'outil est guidé dans un tube de guidage (3) et dans un tube de pose (4), et
(c) deux roues de transport (6, 7) disposées au tube de guidage (3), qui entraînent un moteur (61), (transportent) le câble à travers le tube de guidage (3) et le tube de pose (4),
caractérisé en ce que,
(d) le dispositif de tronçonnage (8) présente une contre-lame (82), et la lame (81) et la contre-lame (82) forment un entonnoir pour introduire le câble dans le tube de pose (4).

2. Outil selon la Revendication 1,
caractérisé en ce, que le moteur est un moteur électrique, dont le nombre de tours et/ou le nombre de rotations, etc commande le manipulateur.

3. Outil selon la Revendication 1 ou 2,
caractérisé en ce qu'à l'outil est monté un dispositif de changement d'outil (2).

4. Outil selon une quelconque des Revendications 1 à 3,
caractérisé en ce, qu'un levier serre le câble à bloc pendant la position de repos.

5. Outil selon la Revendication 4,
caractérisé en ce, que le levier de serrage est actionné à air comprimé.

6. Outil selon la Revendication 4 ou 5,
caractérisé en ce, qu'un détecteur de proximité guide la position opérationnelle du levier de serrage.

Fig. 1

Fig. 2

EP 0 259 394 B1